# EUROPEAN PATENT APPLICATION

(11) **EP 4 614 750 A1**
(43) Date of publication of application: **10.09.2025**
(21) Application number: 25162450.8
(22) Date of filing: 07.03.2025
(51) Int. Cl.: H02H 3/087, H02H 3/20, H02H 5/04

(54) **PROTECTION AND SENSING SYSTEMS AND METHODS**

(30) Priority: 08.03.2024 US 202463562797 P
(71) Applicant: Littelfuse, Inc., Rosemont, Illinois 60018 (US)
(72) Inventor: Golubovic, Boris, Rosemont, 60018 (US); Martinez, Cesar, Rosemont, 60018 (US)
(74) Representative: Arnold & Siedsma

(57) **Abstract**

A circuit protection apparatus. The apparatus includes a solid-state disconnect electronic component (202) , and a sensor (204) coupled to the solid-state disconnect electronic component (202). The solid-state disconnect electronic component (202) is configured to disconnect an operational electronic component (212) and a power source (206) upon the sensor (204) detecting a fault condition.

## Description

### CROSS-REFERENCE TO RELATED APPLICATIONS

The present application claims the benefit of priority to U.S. Provisional Patent Appl. No. 63/562,797 to Golubovic et al., filed March 8, 2024, and entitled "Protection and Sensing Systems and Methods".

### TECHNICAL FIELD

The present disclosure relates generally to the field of circuit protection devices and, in particular, to solid state battery disconnect and protection circuits.

### BACKGROUND

Electrical circuits that protect rechargeable elements, such as, for example, rechargeable electric vehicle (EV) batteries, are well-known. These rechargeable elements can be dangerous if they operate at a voltage and/or current that exceeds a safe limit. To protect against that, overcurrent protection devices are used, which withstand a maximum current allowed before current rise is interrupted.

Some circuit protection devices include contactor devices, which are electrically controlled switches used for switching an electrical power circuit (e.g., in an electric vehicle). In a typical configuration, a contactor includes an electromagnet coil and a movable, electrically conductive core disposed within or adjacent the coil. The core is attached to an electrically conductive bridge. When the coil is energized, it produces an electromagnetic field that shifts the core such that the bridge is moved into engagement with a pair of stationary contacts. The bridge provides an electrically conductive pathway between the contacts and allows current to flow through the contactor (e.g., from an automobile a battery to various electrical systems within an automobile). When the coil is deenergized, the bridge moves away from the stationary contacts and the electrical pathway is broken, thereby arresting the flow of current through the contactor.

Conventional contactor systems are used to disconnect main devices (e.g., motor from a battery) in the event of a fault condition is detected (e.g., an overcurrent, etc.). These contactors need to be capable of switching full operating voltage/current. High current/power switching typically results in arcing and device degradation and/or failure. It may also reduce life of other electrical/electronic systems connected to such contactors and increasing maintenance costs. Existing contactor systems use various arc quenching techniques, which are, typically, large in size, weight, cost, and do not provide the requisite protection to electrical/electronic systems which these contactors are coupled to.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

In some implementations, the current subject matter relates to an apparatus that may be configured to provide circuit protection to one or more operational electronic components, such as, for example, but not limited to, a motor, a rechargeable battery, and/or any other component. The apparatus may include a solid-state disconnect electronic component, and, optionally, a sensor coupled to the solid-state disconnect electronic component. The solid-state disconnect electronic component may be configured to disconnect an operational electronic component from a power source upon the sensor detecting a fault condition.

In some implementations, the current subject matter may be configured to include one or more of the following optional features. In some implementations, a solid-state disconnect housing may include the solid-state disconnect electronic component. The solid-state disconnect electronic component may include at least one solid state switch (e.g., IGBT, MOSFET, etc.). In some example, non-limiting implementations, the solid-state disconnect electronic component may include a fast current sensor to detect, for instance, overcurrent and/or any other conditions. In some example, non-limiting implementations, a solid-state disconnect housing may include the solid-state disconnect electronic component and the sensor. A first terminal of the sensor may be coupled to a first terminal of the power source and the operational electronic component may be coupled to a second terminal of the power source. The solid-state disconnect electronic component may be coupled to a second terminal of the sensor. In some example, non-limiting implementations, the sensor may be coupled to a battery management system (BMS) and may be configured to provide various data (e.g., current values, voltage values, and/or any other parameters) to the BMS, which, in turn, may use these values to control various operational aspects of the battery.

In some implementations, the operational electronic component may include a motor, a power source, a power consuming element, a direct current/direct current power supply, an alternating current/direct current power supply, and/or any combination thereof.

In some implementations, the solid-state disconnect electronic component may provide short circuit protection to the operational electronic component and/or the power source and/or any other electronic component, which may be caused by various operational faults, including faults in the operational electronic component, any interconnecting components, the power source, and/or any other electronic component.

In some implementations, the solid-state disconnect electronic component may perform operational on/off switching.

In some implementations, the solid-state disconnect electronic component may monitor at least one of: a current supplied to the operational electronic component from the power source, a voltage supplied to the operational electronic component from the power source, an operating temperature, and any combination thereof.

In some implementations, the power source may be a battery.

In some implementations, a let-through current of the solid-state disconnect electronic component is in a range of approximately 100 amperes to approximately 1200 amperes with a response time being less than 10 microseconds (e.g., in a range of approximately 400 to approximately 800 amperes with a response time of being less than 10 microseconds, in a range of 100 amperes to approximately 400 amperes with a response time of being less than 8 microseconds, etc.). Alternatively, or in addition, the let-through current may be approximately 2-3 time of a rated current (and/or any other factors of the rated current).

In some implementations, the operational electronic component may be coupled to the power source via a second main relay electronic component. The second main relay component may be coupled to a control system.

In some implementations, the apparatus may also include at least one processor configured to control operation of the solid-state disconnect electronic component.

In some implementations, the fault condition may include at least one of the following: a short circuit, a current surge above a predetermined threshold current, a voltage surge above a predetermined threshold voltage, a temperature above a predetermined threshold temperature, and any combination thereof.

In some implementations, the current subject matter relates to a solid-state disconnect apparatus. The apparatus may include a solid-state disconnect electronic component including at least one processor, and at least one memory storing instructions that, when executed by the processor, cause the processor to disconnect an operational electronic component from a power source upon a sensor detecting a fault condition.

In some implementations, the current subject matter relates to a system that may be configured to provide circuit protection to one or more operational electronic components and/or the power source and/or any other electronic component, which may be caused by various operational faults, including faults in the operational electronic component, any interconnecting components, the power source, and/or any other electronic component. The system may include a plurality of solid-state disconnect electronic components. Each of the plurality of solid-state disconnect electronic components may be coupled to a sensor in a plurality of sensors. The plurality of solid-state disconnect electronic components may be coupled to an operational electronic component. At least one solid-state disconnect electronic component in the plurality of solid-state disconnect electronic components may be configured to disconnect the operational electronic component from a power source upon the sensor of the at least one solid-state disconnect electronic component detecting a fault condition.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed implementations. In the drawings,
FIG. 1 illustrates an example of an electrical/electronic system that may incorporate circuit monitoring/sensing and protection components/systems, according to some implementations of the current subject matter;
FIGS. 2a-b illustrate example circuit protection systems, according to some implementations of the current subject matter;
FIG. 3 illustrates an architecture that may include various electronic components that may be incorporated into the systems shown in FIGS. 2a-b, according to some implementations of the current subject matter;
FIG. 4 illustrates an example system that may include multiple solid-state battery disconnect systems, according to some implementations of the current subject matter;
FIG. 5 illustrates an example plot showing operational characteristics/results of one or more experimental setups of the systems shown in FIGS. 2a-b;
FIG. 6 illustrates an example showing a level threshold versus slope detector and may be representative of operation of the systems, shown in FIG. 2a-b; and
FIG. 7 illustrates an example of a processing component that may be used by the solid-state battery disconnect system, according to some implementations of the current subject matter.

The drawings are not necessarily to scale. The drawings are merely representations, not intended to portray specific parameters of the disclosure. The drawings are intended to depict exemplary implementations of the current subject matter, and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings, where implementations of a system and method are shown. The devices, system(s), component(s), etc., may be embodied in many different forms and are not to be construed as being limited to the example implementations set forth herein. Instead, these example implementations are provided so this disclosure will be thorough and complete, and will fully convey the scope of the current subject matter to those skilled in the art.

To address these and potentially other deficiencies of currently available solutions, one or more implementations of the current subject matter relate to methods, systems, articles of manufacture, and the like that can, among other possible advantages, provide circuit monitoring/sensing and protection to one or more operational electronic components, e.g., motors, power sources, power consuming element(s), a direct current/direct current (DC/DC) power suppl(ies), an alternating current/direct current (AC/DC) power suppl(ies), and/or any other electrical/electronic devices and/or systems.

Current approaches for overcurrent detection are based on level detection, e.g., the current must reach a certain value before an overcurrent protection device detects the overcurrent and acts to interrupt a current rise. The maximum current can grow potentially high before the overcurrent protection device completes a sequence of actions needed to mitigate the current.

Some overcurrent protection systems and devices, such as those used in high voltage DC applications with capacitive loads that can result in high inrush currents during power up, implement various pre-charge circuits to prevent damage to system components by blocking high amperage current spikes. In these circuits, pre-charging of powerline voltages is a preliminary mode that limits the inrush current.

In electric vehicle (EV) applications, battery disconnects are implemented using contactors. Overcurrent protection is implemented using a combination of contactors controlled by specific circuitry and additional protection elements, such as, for example fuses, pyrofuses, etc. Pre-charge control is implemented using additional dedicated circuitry. In the EV applications, large capacitive load is the DC link in the electric motor, where a DC link capacitor can be a sum of several parallel capacitors in subunits within the EV, e.g., one for the electric motor, another for the air conditioning compressor, another for the window enabling, etc. Pre-charging of the DC link capacitor can occur with each vehicle start. The battery voltage may be different in each vehicle start, depending on the state of the battery charge. Thus, the battery voltage may be any value within the operating range of the battery, e.g., 550V-800V in an 800V battery system. The pre-charge circuit can limit the inrush current to slowly charge the downstream DC link capacitor. Once the voltage of the DC link capacitor is close to that of the battery, the main switches are permitted to close. Thus, pre-charge circuits allow the current to flow in a controlled manner during vehicle startup.

In some scenarios, pre-charge circuits can include an auxiliary switch positioned in series with a large value resistance and placed in parallel with the main switch. The DC link capacitor is slowly charged (as determined by the resistance value) while the main switch is open, and the auxiliary switch closed. Once the DC link capacitor is sufficiently charged (e.g., its voltage is close to the battery voltage), the main switch is closed all the way, and the battery is able to safely supply power to the vehicle.

In some implementations, the current subject matter provides a circuit monitoring/sensing and protection system that may be configured to perform power source (e.g., battery, etc.) disconnection upon detection of certain faults (e.g., a short circuit, an overcurrent, etc.). The system may include a solid-state disconnect electronic component (e.g., a solid-state battery disconnect electronic component) and a sensor coupled to a relay electronic component, where the solid-state disconnect electronic component may be configured to disconnect one or more operational electronic components and/or a power source upon the sensor detecting a fault condition. The fault condition may, for example, include at least one of the following: a short circuit, a current surge above a predetermined threshold current, a voltage surge above a predetermined threshold voltage, a temperature above a predetermined threshold temperature, and any combination thereof. One or more components of the system may be disposed in one or more housings. For example, the solid-state disconnect electronic component may be disposed in a solid-state disconnect housing and may include at least one solid state switch component also disposed therein. Another housing may include the solid-state disconnect housing and the sensor. As can be understood, a single or multiple housings may be used to house the solid-state disconnect electronic components and the sensor, where both may be disposed in a same or different housings.

The solid-state disconnect electronic component may be configured to provide a short circuit protection to at least one of: the operational electronic component and/or the power source. For example, the solid-state disconnect electronic component may perform operational on/off switching to connect/disconnect the operational electronic component and/or the power source. In some implementations, the solid-state disconnect electronic component may be configured to monitor at least one of: a current supplied to the operational electronic component from the power source, a voltage supplied to the operational electronic component from the power source, an operating temperature, or any combination thereof. The power source may include one or more batteries (e.g., automotive batteries). In some example, non-limiting implementations, the current subject matter system may be characterized by a let-through current of the solid-state disconnect electronic component, which may be in a range of approximately 100 amperes to approximately 1200 amperes with a response time being less than 10 microseconds (e.g., in a range of approximately 400 to approximately 800 amperes with a response time of being less than 10 microseconds, in a range of 100 amperes to approximately 400 amperes with a response time of being less than 8 microseconds, etc.). Alternatively, or in addition, the let-through current may be approximately 2-3 time of a rated current (and/or any other factors of the rated current). As can be understood, the current subject matter is not limited to these values and other implementations are within the scope of the current disclosure.

In some implementations, the sensor and the power source may include one or more of their respective terminals. One terminal of the sensor may be coupled to one of the terminals of the power source and another terminal of the sensor may be coupled to the solid-state disconnect electronic component. Another terminal of the power source may be coupled to the operational electronic component. The operational electronic component may include at least one of the following: a motor, a power source, and/or any combination thereof.

In some implementations, the system may include a pre-charge relay electronic component and a first main relay electronic component. The operational electronic component may be coupled to the power source via a second main relay electronic component. The second main relay component may be coupled to a control component (e.g., one or more processing components) and the second main relay component may include a reduced contactor component.

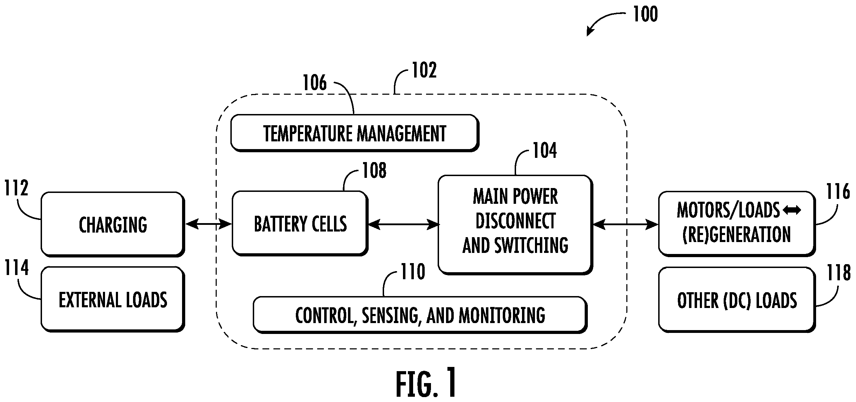

FIG. 1 illustrates an example of an electrical/electronic system 100 that may incorporate circuit monitoring/sensing and protection components/systems, according to some implementations of the current subject matter. The system 100 may be a power source (e.g., battery, etc.) system architecture that may be disposed, for example, in an electrical vehicle (EV). The system 100 may include a battery system 102 that may include one or more main power disconnect and/or switching components 104, one or more temperature management electronic components 106, one or more battery cells 108, and one or more control, sensing, and/or monitoring electronic components (e.g., processors) 110. The battery system 102 may be subject to various external loads 114, motor/load and/or generation and/or regeneration 116, and/or any other loads (e.g., direct current (DC) loads) 118. The battery cells 108 may be charged using one or more external charging components 112.

One or more components of the system 102 (e.g., components 110) may be communicatively coupled using one or more communications networks. The communications networks may include one or more of the following: a wired network, a wireless network, a metropolitan area network ("MAN"), a local area network ("LAN"), a wide area network ("WAN"), a virtual local area network ("VLAN"), an internet, an extranet, an intranet, and/or any other type of network and/or any combination thereof.

Further, one or more components of the system 102 (e.g., components 110) may include any combination of hardware and/or software. In some implementations, one or more components of the system 102 may be disposed on one or more computing devices, such as, server(s), database(s), personal computer(s), laptop(s), cellular telephone(s), smartphone(s), tablet computer(s), virtual reality devices, and/or any other computing devices and/or any combination thereof. In some example implementations, one or more components of the system 102 may be disposed on a single computing device and/or may be part of a single communications network. Alternatively, or in addition to, such services may be separately located from one another. A service may be a computing processor, a memory, a software functionality, a routine, a procedure, a call, and/or any combination thereof.

One or more components of the system 102 may include a processor and a memory, and it is understood that the processing circuitry may contain additional components, including processors, memories, error and parity/CRC checkers, data encoders, anti-collision algorithms, controllers, command decoders, security primitives and tamper-proofing hardware, as necessary to perform the functions described herein. One or more components of the environment 102 may further include one or more displays and/or one or more input devices. The displays may be any type of devices for presenting visual information such as a computer monitor, a flat panel display, and a mobile device screen, including liquid crystal displays, light-emitting diode displays, plasma panels, and cathode ray tube displays. The input devices may include any device for entering information into the user's device that is available and supported by the user's device, such as a touchscreen, keyboard, mouse, cursor-control device, touchscreen, microphone, digital camera, video recorder or camcorder. These devices may be used to enter information and interact with the software and other devices described herein.

In some example implementations, one or more components of the system 102 may execute one or more applications, such as software applications, that enable, for example, network communications with one or more components of system 102 and transmit and/or receive data.

The main power disconnect and/or switching components 104 may be configured to include one or more circuit protection electronic devices and/or systems, such as, for example, solid state battery disconnects, one or more electrical contactors, etc. The components 104 may be configured to protect various operational electronic components, such as, for example, components 116 from fault conditions, e.g., short circuits, current surges, etc., by disconnecting components 116 (and/or loads 114 and/or loads 118) from the system 102.

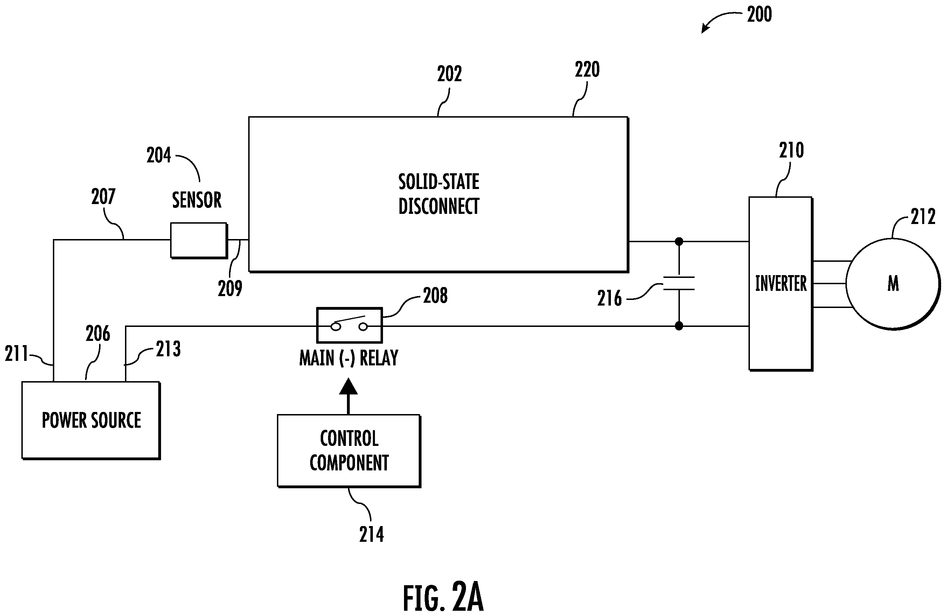

FIGS. 2a-b illustrate example circuit protection systems 200 and 230, respectively, according to some implementations of the current subject matter. The systems 200 and/or 230 may be include solid-state disconnect systems (e.g., solid-state battery disconnect systems, such as, for instance, SSBDs or SSDs) that may be implemented in energy storage systems (ESSs), such as, for example, batteries (e.g., automotive and/or any other type), etc. One of the benefits of such SSDs is that they do not require any mechanical parts, thereby providing an enhanced reliability and a reduced maintenance cost. Moreover, these systems provide a very fast and resettable short-circuit protection, which allows for a quick recovery from false triggers (e.g., false detection of a short circuit). The SSDs may further enable control of pre-charge (inrush) current, thereby reducing component count. The current subject matter's SSDs provide fault diagnostics, thereby providing voltage and/or current sensing functionalities.

In some implementations, the systems 200 and/or 230, as shown in FIGS. 2a-b may provide various functions, such as, for example, operational on/off switching of operational electronic components that may be coupled to such systems, short circuit protection along, pre-charge functionalities, monitoring and/or control, along with other functions. Moreover, the systems 200 and/or 230 enable sensing of various operational parameters, such as, for example, current sensing, voltage sensing, temperature sensing, etc.

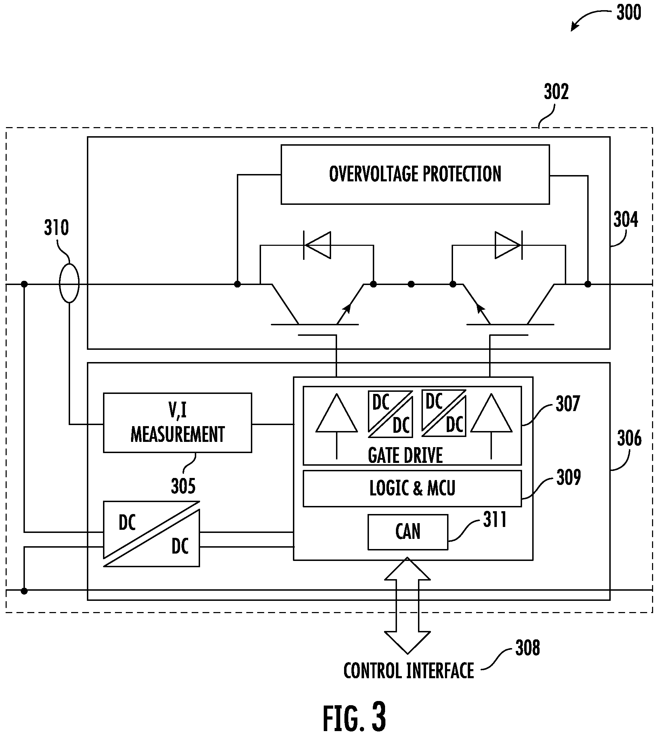

Referring to FIG. 2a, the system 200 may include a solid-state disconnect component 202 and a sensor 204 coupled to the solid-state disconnect component 202. The solid-state disconnect component 202 may include various components, including, but not limited to, a solid-state disconnect switch, such as, for example, as shown in FIG. 3. The solid-state disconnect component 202 may be configured to disconnect an operational electronic component, e.g., motor, 212, from a power source, e.g., battery, 206 upon the sensor 204 detecting a fault condition. The fault condition may, for example, but not limited to, include at least one of the following: a short circuit, a current surge above a predetermined threshold current, a voltage surge above a predetermined threshold voltage, a temperature detected to be above a predetermined threshold temperature, and any combination thereof. The sensor 204 may, for example, be a current sensor, a voltage, sensor, a temperature sensor, and/or any other sensor. The sensor 204 may be associated and/or be part of a power (e.g., battery, etc.) management system and may supply various information/data to the power management system to enable it to perform various functions associated with managing power (e.g., battery, etc.) resources, operational characteristics, and/or any other parameters. The fault condition may include at least one of the following: a short circuit, a current surge above a predetermined threshold current, a voltage surge above a predetermined threshold voltage, a temperature above a predetermined threshold temperature, and any combination thereof.

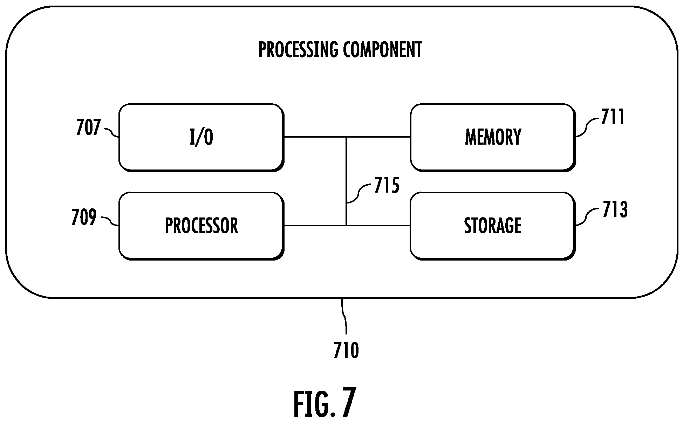

The solid-state disconnect component 202 may be coupled to a terminal 209 of the sensor 204. The sensor 204, via its terminal 207, may be coupled to the (e.g., battery, etc.) terminal 211. The terminal 211 may be a positive terminal. The solid-state disconnect component 202 may include various other components, including circuitry show in FIG. 3 as well as a processing component, such as, processing component 710 shown in FIG. 7, which may control operation of the solid-state disconnect component 202, and in particular, opening and/or closing of the relays 201 and/or 203.

The operational electronic component 212 may be coupled, via an interrupter component 210, to the solid-state disconnect component 202 and to a (e.g., battery, etc.) terminal 213 of the power source 206 via a main relay component 208. The terminal 213 may be a negative terminal. As can be understood, terminals 211 and 213 may be positive or negative. The main relay component 208 may also be coupled to a control component 214. The control component 214 may, for example, be configured to perform various functions associated, such as, management of electronics of the power source (e.g., a cell, a battery pack, etc.). It may ensure that the power source operates within its safe operating parameters. The control component 214 may monitor the state of health (SOH) of the power source, collect data, control environmental factors that affect the power source, balance them to ensure the same voltage across battery cells, and/or perform any other functions. The control component 214 may include a processing component, which may be similar to the processing component 710 shown in FIG. 7.

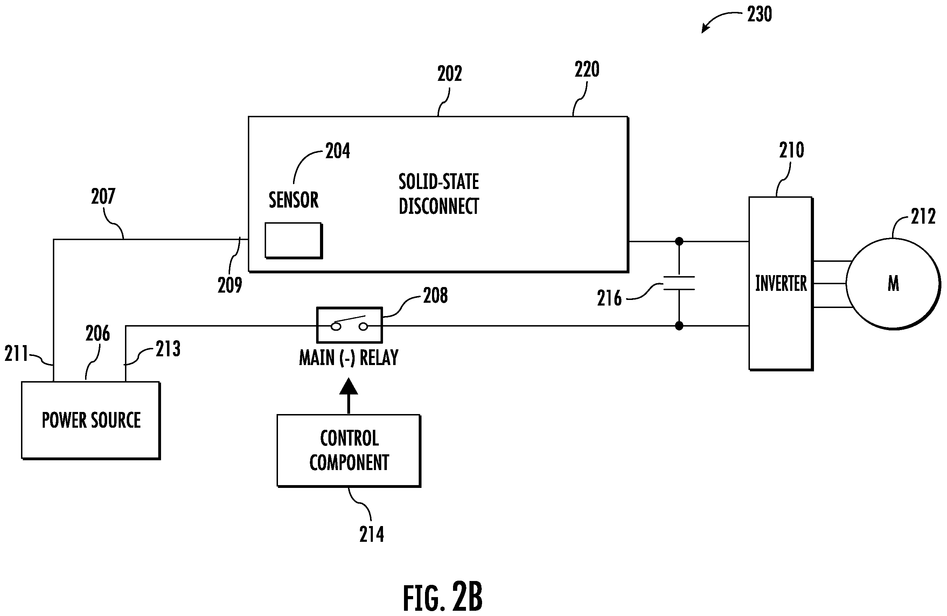

In some implementations, as shown, for example, in FIG. 2a, the solid-state disconnect system 202 may be incorporated into a housing component 220 that may house a solid-state switch and/or any other electronic components, processing components, etc. such as those shown in FIGS. 3 and/or 7. The housing component 220 may be a printed circuit board and/or any other mechanical, electrical, and/or electro-mechanical component(s) that may be configured for use with the solid-state disconnect system 202, and/or any of its associated components. The housing component 220 may also incorporate the sensor 204. Further, in some example, non-limiting implementations, the housing component 222 may incorporate the sensor 204, such as, in the system 230, as shown in FIG. 2b.

In some implementations, as stated herein, the solid-state disconnect component 202 may provide a short circuit protection and/or an inrush current protection to the operational electronic component 212. The component 202 may perform operational on/off switching. It may also monitor at least one of: a current supplied to the operational electronic component 212 from the power source 206, a voltage supplied to the operational electronic component 212 from the power source 206, an operating temperature of the component 212 and/or the power source 206 and/or the relay component 202, and/or any other device, and/or any combination thereof. In some implementations, if the solid-state disconnect 220 is used in one of the terminals associated with the power source (e.g., terminal 211), and its opening and closing is synchronized with the electromechanical relay (e.g., main relay 208) on the opposite terminal associated with the power source (e.g., terminal 213), then main relay 208 would not switch current on. Thus, the solid-state disconnect system 200 (or 230 as shown in FIG. 2b) allows use of a smaller and cheaper contactor-type device at an opposite terminal of the power source because it does not need to handle arc quenching.

In some example, non-limiting, embodiments, a let-through current of the solid-state disconnect system 200 may be in a range of approximately 100 amperes to approximately 1200 amperes with a response time being less than 10 microseconds (e.g., in a range of approximately 400 to approximately 800 amperes with a response time of being less than 10 microseconds, in a range of 100 amperes to approximately 400 amperes with a response time of being less than 8 microseconds, etc.). Alternatively, or in addition, the let-through current of the system 200 may be approximately 2-3 time of a rated current (and/or any other factors of the rated current). As can be understood, the current subject matter is not limited to these values and other implementations are within the scope of the current disclosure.

In some implementations, the main relay 208 may include a reduced contactor component. The reduced contactor component may be a contactor that is simplified and reduced in specifications to operate after main solid-state contactor is open. Under such conditions, this component may switch at low current levels only (e.g., leakage levels), as there are no large arcing to suppress. This component's purposes may include providing air-gap separation and compliance with safety standards. The reduced/simplified performance contactor may provide high current carrying capability with low resistance. In some example, non-limiting implementations, the reduced contactor may be configured so that there is no need for breaking an arc as in standard contactors used in traditional systems. It may provide a high contact force and a low contact resistance during an on-state. When open, it may include an air gap that meets insulation resistance conditions for testing and/or standards. It may also have a lower cost, volume/space, optimized coil/switching currents, as well as afford various other benefits.

FIG. 3 illustrates an architecture 300 that may include various electronic components that may be incorporated into the systems 200 and/or 230 shown in FIGS. 2a-b, respectively. For example, the architecture 300 may include one or more power module electrical and/or control elements, including, but not limited to one or more switching devices (e.g., 4x IGBT, 4x diodes, 4x protection, etc.), a control and communication board, one or more current sensing elements, one or more internal and/or external power supplies, cold-plate thermal/mechanical interface, and/or any other components. For example, the architecture 300 may include a solid-state disconnect system 302 (similar to the system 202 shown in FIGS. 2a-b) that may include an overvoltage protection block 304, a measurement and control block 306 (which may include components 305 designed to monitor, detect, and/or measure, voltage (V), current (I), etc., gate drives 307, logic and master controller unit(s) (MCUs) 309, and/or any other electronic components 311), and, optionally, a sensor (e.g., a current sensor) 310 that may detect and supply current, voltage, etc. values to the voltage, current, etc. component of the block 306. In some implementations, the solid-state disconnect system 302 may be coupled to a control interface 308, which may provide various operational control functionalities to the architecture 300. Various components, blocks, etc. of the architecture 300 may incorporate one or more of insulated gate bipolar junction transistors (IGBTs), semiconductor(s), power metal-oxide semiconductor field-effect transistor(s) (MOSFETs), thyristor(s), silicon-controlled rectifier(s) (SCRs), triode(s) for alternating current (TRIACs), and/or any other suitable high-power controlled solid-state device, and/or any combinations thereof

In some implementations, the systems 200 and/or 230 shown in FIGS. 2a-b and/or architecture 300, as shown in FIG. 3, may be characterized by one or more of the following example, experimental, non-limiting parameters:

| **Parameter** | **Symbol** | **Values** | **Unit** | **Conditions** |
|---|---|---|---|---|
| Nominal system voltage | V(sys) | 800 | V | Nominal battery voltage (suitable for 400 V-class and 800 V-class) |
| Battery min-max voltage range | V(batt) | 250 - 960 | V | To be verified for whole temperature range. |
| | | | | Liquid cooling system assumed to ON. |
| Max rated DC current (forward and reverse) | I(sys) | 400 | A | Fully symmetric, ton > 100 ms; basic module plan to be able to use multiple units in-parallel for higher I rating |
| Current trip level | I(trip) | 480 | A | ~120% rated current; |
| | | | | accuracy ±50 A over entire temperature range |
| Disconnect (on demand, bidirectional) | I(switch) | 400 | A | On 20 µH load |
| Voltage drop @ 400A | V(on) | 2.5 | V | Dissipates ~1 kW at full current rating; Prototypes tested ~2.5 V with industrial commercially available cooling plate |
| Off state leakage | I(leak) | 125 | µA | @25°C; is this aligned with the need? |
| Pre-charge time | t(pre) | 100 | ms | e.g., load=1500 µF, system inductance >5 µH, 400 V |
| | | 200 | ms | e.g., load=1500 µF, system inductance >5 µH, 800 V |
| Inductive load (for short circuit test) | L(sc) | 3 | µH | e.g., 3 µH → ~3 m cable @1 µH/m |
| | | | | e.g., 3 µH → 2 µH battery + 1 m cable @ 1 µH/m |
| Isolation voltage @ 1mA current | VISOL | 4000 | Vrms | 60 s "hipot" testing from any terminal to DC, except VBAT+ and VEH+ |
| Cooling | | Liquid | | Requires external cooling plate; tested with commercially available 'industrial' cooling plate and heat exchanger |
| Communication & control | | CAN-bus | | Other communication protocols and interfaces can be considered in production units |

As can be understood, the above parameters are provided herein for merely illustrative, exemplary purposes. The current subject matter is not limited to any of these parameters and may be configured to operate using any desired values, characteristics, etc.

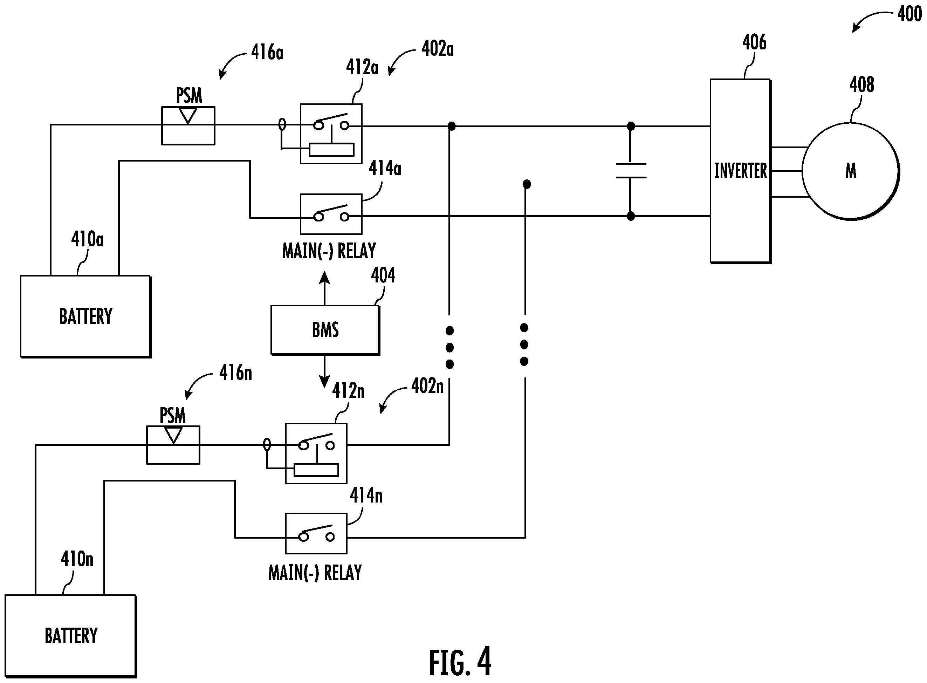

FIG. 4 illustrates an example system 400 that may include multiple solid-state disconnect systems (similar to those shown in FIGS. 2a-b), according to some implementations of the current subject matter. As shown in FIG. 4, the system 400 may include solid-state disconnect systems 402 (a, ...n), all of which may be coupled to a power source management system (e.g., battery management system (BMS)) 404, an inverter 406, and a motor 408 (via the inventor 406). In some implementations, the BMS 404 may be configured to perform various control and/or management functionalities of the architecture 400. The BMS 404 may include one or more processing components, such as, for example, shown in FIG. 7, which may be configured to perform one or more of the above control/management functionalities.

Each system 402 may be coupled to a respective power source (e.g., battery, etc.) 410 (a, ..., n), and may include a respective pre-charge relay 412 (a, ..., n) and a main relay 414 (a, ..., n), which are similar to relays 201, 203, respectively. Moreover, each system 402 may include a respective pyro safety module (e.g., a one-time, on-demand disconnect device) 416 (a, ..., n). A pyro safety module 416 may provide additional protection, and may, for example, include one or more fuses and/or pyrofuses.

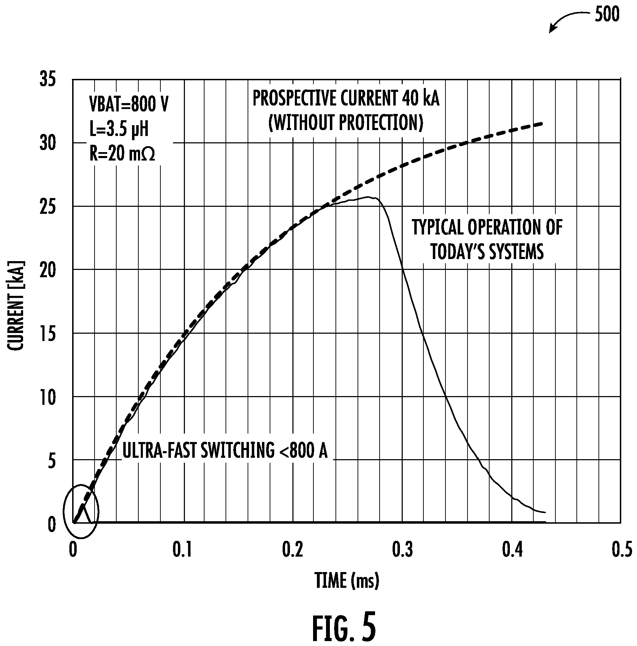

FIG. 5 illustrates an example plot showing operational characteristics/results of one or more experimental setups of the systems 200 and/or 230 shown in FIGS. 2a-b, respectively. As shown in FIG. 5, plot 500 illustrates example performance of the system(s), where a maximum operation voltage was set at 800 V for 400 A single module (e.g., multiple modules (as shown in FIG. 4) may be paralleled for higher current ratings).

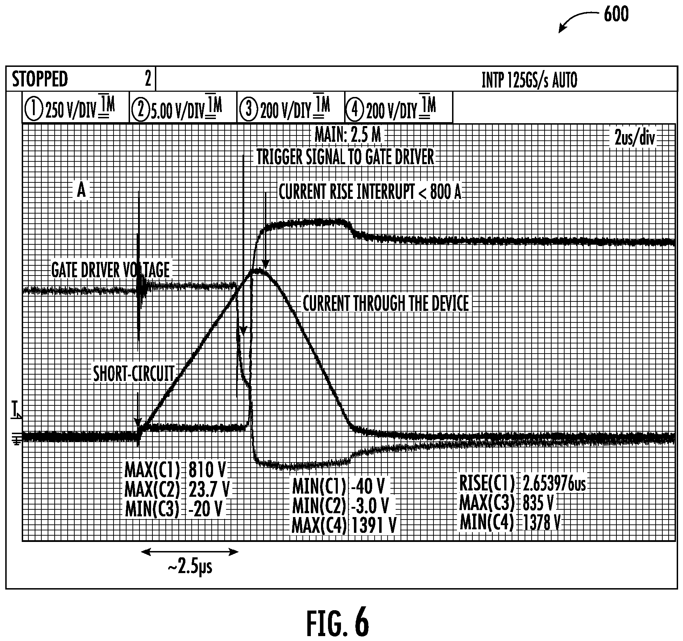

FIG. 6 illustrates an example plot 600 showing a level threshold versus slope detector and may be representative of operation of the systems 200, 230, shown in FIG. 2a-b, respectively. As shown in FIG. 6, the solid-state disconnect systems are operable to monitor a rate of change of current and a value of current. The current is monitored to determine whether the rate of change of the current exceeds a first predetermined threshold and to determine whether the value of the current exceeds a second predetermined threshold. The second predetermined threshold may be a specific current value. As shown in FIG. 6, an overcurrent fault may exist in the case that the first or second predetermined threshold is exceeded. That is, if dI/dt exceeds a specific value, the systems may begin a sequence of actions until the current rise is interrupted. The first predetermined threshold may be triggered before the second predetermined threshold is triggered. However, in other cases in which the current increases gradually, the first predetermined threshold may not be tripped.

In some implementations, the overcurrent protection circuit may be resettable. That is, when the circuit protection is tripped, the systems 200, 230 may try again after a certain time to verify if the overcurrent condition remains, and/or if it was caused by a noise of some other transient effect. Upon reconnection, a similar method (e.g., dI/dt) may be used as criteria to determine if the overcurrent event remains. In some implementations, the current subject matter system may be configured perform ultra-fast switching (e.g., with a response time of less than 10 microseconds) for let-through currents between approximately 400 amperes (A) to approximately 800 A.

FIG. 7 illustrates an example of a processing component 710 that may be used by the solid-state disconnect systems shown in FIGS. 2a-3, as discussed herein, according to some implementations of the current subject matter. The processing component 710 may include an input/output (I/O) device 707, a processor 709, a memory 711, and a storage 713. Each of the components 707-713 may be interconnected using a system bus 715. The processor 709 may be configured to process instructions for execution within the processing component 710. In some implementations, the processor 709 may be a single-threaded processor. Alternatively, or in addition, the processor 709 may be a multi-threaded processor. The processor 709 may be further configured to process instructions stored in the memory 711 and/or in the storage 713, including, but not limited to, receiving and/or sending information through the I/O device 707. The memory 711 may store information within the processing component 710. In some implementations, the memory 711 may be a computer-readable medium. Alternatively, or in addition, the memory 711 may be a volatile memory unit. In yet some implementations, the memory 711 may be a non-volatile memory unit. The storage 713 may be capable of providing mass storage for the processing component 710. In some implementations, the storage device 713 may be a computer-readable medium. Alternatively, or in addition, the storage 713 may be a floppy disk device, a hard disk device, an optical disk device, a tape device, non-volatile solid-state memory, or any other type of storage device. The I/O device 707 may provide input/output operations for the processing component 710. In some implementations, the I/O device 707 may include a keyboard and/or pointing device. Alternatively, or in addition, the I/O device 707 may include a display unit for displaying graphical user interfaces.

The various elements of the components as previously described with reference to FIGS. 1-7 may include various hardware elements, software elements, or a combination of both. Examples of hardware elements may include devices, logic devices, components, processors, microprocessors, circuits, processors, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), memory units, logic gates, registers, semiconductor device, chips, microchips, chip sets, and so forth. Examples of software elements may include software components, programs, applications, computer programs, application programs, system programs, software development programs, machine programs, operating system software, middleware, firmware, software modules, routines, subroutines, functions, methods, procedures, software interfaces, application program interfaces (API), instruction sets, computing code, computer code, code segments, computer code segments, words, values, symbols, or any combination thereof. However, determining whether an implementation is implemented using hardware elements and/or software elements may vary in accordance with any number of factors, such as desired computational rate, power levels, heat tolerances, dielectric materials used, processing cycle budget, input data rates, output data rates, memory resources, data bus speeds and other design or performance constraints, as desired for a given implementation.

One or more aspects of at least one implementation may be implemented by representative instructions stored on a machine-readable medium which represents various logic within the processor, which when read by a machine causes the machine to fabricate logic to perform the techniques described herein. Such representations, known as "IP cores", may be stored on a tangible, machine readable medium and supplied to various customers or manufacturing facilities to load into the fabrication machines that make the logic or processor. Some implementations may be implemented, for example, using a machine-readable medium or article which may store an instruction or a set of instructions that, if executed by a machine, may cause the machine to perform a method and/or operations in accordance with the implementations. Such a machine may include, for example, any suitable processing platform, computing platform, computing device, processing device, computing system, processing system, computer, processor, or the like, and may be implemented using any suitable combination of hardware and/or software. The machine-readable medium or article may include, for example, any suitable type of memory unit, memory device, memory article, memory medium, storage device, storage article, storage medium and/or storage unit, for example, memory, removable or non-removable media, erasable or non-erasable media, writable or rewritable media, digital or analog media, hard disk, floppy disk, Compact Disk Read Only Memory (CD-ROM), Compact Disk Recordable (CD-R), Compact Disk Rewritable (CD-RW), optical disk, magnetic media, magneto-optical media, removable memory cards or disks, various types of Digital Versatile Disk (DVD), a tape, a cassette, or the like. The instructions may include any suitable type of code, such as source code, compiled code, interpreted code, executable code, static code, dynamic code, encrypted code, and the like, implemented using any suitable high-level, low-level, object-oriented, visual, compiled and/or interpreted programming language.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in implementations.

At least one computer-readable storage medium may include instructions that, when executed, cause a system to perform any of the computer-implemented methods described herein.

Some implementations may be described using the expression "one implementation" or "an implementation" along with their derivatives. These terms mean that a particular feature, structure, or characteristic described in connection with the implementation is included in at least one implementation. The appearances of the phrase "in one implementation" in various places in the specification are not necessarily all referring to the same implementation. Moreover, unless otherwise noted the features described above are recognized to be usable together in any combination. Thus, any features discussed separately may be employed in combination with each other unless it is noted that the features are incompatible with each other.

It is emphasized that the Abstract of the Disclosure is provided to allow a reader to quickly ascertain the nature of the technical disclosure. It is submitted with the understanding that it will not be used to interpret or limit the scope or meaning of the claims. In addition, in the foregoing Detailed Description, it can be seen that various features are grouped together in a single implementation for the purpose of streamlining the disclosure. This method of disclosure is not to be interpreted as reflecting an intention that the claimed implementations require more features than are expressly recited in each claim. Rather, as the following claims reflect, inventive subject matter lies in less than all features of a single disclosed implementation. Thus, the following claims are hereby incorporated into the Detailed Description, with each claim standing on its own as a separate implementation. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

The foregoing description of example implementations has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific implementations described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes. Thus, the claims set forth below are to be construed in view of the full breadth and spirit of the present disclosure as described herein.

## Claims

1. An apparatus, comprising:
a solid-state disconnect electronic component; and
a sensor coupled to the solid-state disconnect electronic component;
the solid-state disconnect electronic component is configured to disconnect at least one of: an operational electronic component coupled to the solid-state disconnect electronic component or a power source upon the sensor detecting a fault condition, the power source being coupled to at least one of: the solid-state disconnect electronic component and the operational electronic component.

2. The apparatus of claim 1, wherein a solid-state disconnect housing includes the solid-state disconnect electronic component, the solid-state disconnect electronic component includes at least one solid state switch component;
wherein a second housing includes the solid-state disconnect housing and the sensor;
wherein a first terminal of the sensor is coupled to a first terminal of the power source and the operational electronic component is coupled to a second terminal of the power source;
wherein the solid-state disconnect electronic component is coupled to a second terminal of the sensor.

3. The apparatus of any of the preceding claims, further comprising a pre-charge relay electronic component and a first main relay electronic component.

4. The apparatus of any of the preceding claims, wherein the operational electronic component includes at least one of: a motor, a power source, a power consuming element, a direct current/direct current power supply, an alternating current/direct current power supply, or any combination thereof.

5. The apparatus of any of the preceding claims, wherein the solid-state disconnect electronic component provides short circuit protection to at least one of: the operational electronic component or the power source.

6. The apparatus of any of the preceding claims, wherein the solid-state disconnect electronic component performs operational on/off switching.

7. The apparatus of any of the preceding claims, wherein the solid-state disconnect electronic component monitors at least one of: a current supplied to the operational electronic component from the power source, a voltage supplied to the operational electronic component from the power source, an operating temperature, or any combination thereof.

8. The apparatus of any of the preceding claims, wherein the power source is a battery.

9. The apparatus of any of the preceding claims, wherein a let-through current of the solid-state disconnect electronic component is in a range of approximately 100 amperes to approximately 1200 amperes with a response time being less than 10 microseconds.

10. The apparatus of any of the preceding claims, wherein the operational electronic component is coupled to the power source via a second main relay electronic component, wherein the second main relay component is coupled to a control component and the second main relay component includes a reduced contactor component.

11. The apparatus of any of the preceding claims, further comprising at least one processor configured to control operation of the solid-state disconnect electronic component.

12. The apparatus of any of the preceding claims, wherein the fault condition includes at least one of the following: a short circuit, a current surge above a predetermined threshold current, a voltage surge above a predetermined threshold voltage, a temperature above a predetermined threshold temperature, or any combination thereof.

13. A solid-state disconnect apparatus, comprising:
a solid-state disconnect electronic component including
at least one processor; and
at least one memory storing instructions that, when executed by the at least one processor, cause the at least one processor to disconnect an operational electronic component coupled to the solid-state disconnect electronic component and a power source upon a sensor detecting a fault condition, the power source being coupled to at least one of: the solid-state disconnect electronic component and the operational electronic component.

14. A system, comprising:
a plurality of solid-state disconnect electronic components, each of the plurality of solid-state disconnect electronic components is coupled to a sensor in a plurality of sensors, the plurality of solid-state disconnect electronic components being coupled to an operational electronic component;
at least one solid-state disconnect electronic component in the plurality of solid-state disconnect electronic components is configured to disconnect at least one of: the operational electronic component or a power source upon the sensor of the at least one solid-state disconnect electronic component detecting a fault condition.

15. An apparatus, comprising:
a solid-state disconnect electronic component;
a reduced contactor component; and
a sensor coupled to the relay electronic component;
the solid-state disconnect electronic component is configured to disconnect at least one of: an operational electronic component coupled to the solid-state disconnect electronic component or a power source upon the sensor detecting a fault condition, the power source being coupled to at least one of: the solid-state disconnect electronic component and the operational electronic component.
